# EUROPEAN PATENT SPECIFICATION

(11) **EP 2 690 683 B1**
(45) Date of publication and mention of the grant of the patent: **25.12.2019**
(21) Application number: 13177479.6
(22) Date of filing: 22.07.2013
(51) Int. Cl.: H01L 51/52, H01L 51/44, H01L 31/0224

(54) **Transparent conductive oxide thin film substrate, method of fabricating the same, and organic light-emitting device and photovoltaic cell having the same**
Substrat mit Dünnschicht aus transparentem, leitfähigem Oxid, Verfahren zur Herstellung davon und organische lichtemittierende Vorrichtung und photovoltaische Zelle damit
Substrat de film mince d'oxyde conducteur transparent, son procédé de fabrication, dispositif électroluminescent organique et cellule photovoltaïque ayant celui-ci

(30) Priority: 27.07.2012 KR 20120082293
(43) Date of publication of application: 29.01.2014
(73) Proprietor: Corning Precision Materials Co., Ltd., Asan-si, Chungcheongnam-do 336-841 (KR)
(72) Inventor: Kim, Seo Hyun, 336-841 Asan-si, ChungCheongNam-Do (KR); Yoon, Gun Sang, 336-841 Asan-si, ChungCheongNam-Do (KR); Lee, Hyunhee, 336-841 Asan-si, ChungCheongNam-Do (KR); Yoo, Young Zo, 336-841 Asan-si, ChungCheongNam-Do (KR)
(74) Representative: Gulde & Partner

(56) References cited:
- US-A1- 2003 173 894
- US-A1- 2004 113 146
- US-A1- 2009 025 791

## Description

### BACKGROUND OF THE INVENTION

### Field of the Invention

The present invention relates to a transparent conductive oxide thin film substrate, a method of fabricating the same, and an organic light-emitting device (OLED) and photovoltaic cell having the same, and more particularly, to a transparent conductive oxide thin film substrate that has a high level of surface flatness, a method of fabricating the same, and an OLED and photovoltaic cell having the same.

### Description of Related Art

Organic light-emitting devices (OLEDs) used in organic light-emitting display devices are a self-light-emitting device having a light-emitting layer situated between two electrodes. In OLEDs, electrons are injected into a light-emitting layer through a cathode, or an electron injection electrode, and holes are formed in the light-emitting layer through an anode, or a hole injection electrode. Electrons and holes then recombine with each other, thereby generating excitons. When excitons transit from the excited state to the ground state, light is emitted.

Organic light-emitting display devices using an OLED are divided into a top-emission type, a bottom-emission type and a dual-emission type depending on the direction in which light is emitted and into a passive matrix type and an active matrix type depending on the driving mechanism.

In the meantime, organic light-emitting display devices of the related art have the following problems. The process cost is increased due to the problem of the work function involved in selection of a material for a lower electrode, power consumption is then increased resulting from an increase in the driving voltage, and luminance is decreased due to the low electron-hole recombination rate in the light-emitting layer.

In order to improve the efficiency of OLEDs, the electron-hole recombination rate must be increased, which requires lowering the hole injection barrier. Therefore, it is inevitably required to adjust the work function of a transparent conductive oxide (TCO).

The transparent conductive oxide is a substance that is transparent to incident light while conducting electricity like a metal. At present, the transparent conductive oxide is formed as a thin film, and is used as a transparent electrode not only in OLEDs but also in other devices such as a photovoltaic cell. It is essential to design the transparent conductive oxide such that it has a high conductivity while allowing light in the visible light range to pass through. In order for the transparent conductive oxide to be transparent in the visible light range (wavelength from 400 to 700nm), the electronic energy bandgap must be at least 3.1eV, that is, the electromagnetic radiation energy of a 400nm wavelength. Among the oxide semiconductors that satisfy this requirement, ZnO (3.3eV), In₂O₃ (3.7eV), MgO (3.6eV) and SnO₂ (3.6eV) are typical. In general, the transparent conductive oxide has a light transmittance of 80% or greater in the visible light range and, as an electrical characteristic, a resistivity of about 10⁻⁴ Qcm or less. In order to find a substance that is available as a transparent conductive oxide, all studies to day have been performed mainly by conducting doping and alloying to a variety of substances. In particular, In₂O₃ exhibits a lower resistivity than SnO₂ or ZnO. Because of this reason, the substance that was commercialized first and has been used up to the present is Sn-doped In₂O₃ (indium tin oxide: ITO). ITO is a substance that is applied to electrodes for displays, such as a light-emitting diode (LED), a liquid crystal display (LCD) and a plasma display panel (PDP), a photovoltaic cell, or the like. ITO has a low resistivity that is similar to that of metals, i.e. about 10⁻⁴ Qcm in general and about 10⁻⁵ Qcm in the laboratory scale. However, the requirements of cost reduction are great, since In, i.e. a component of ITO, is an expensive rare element, the price of which makes up 20% or more of the fabrication cost in the OLED field for illumination. In an application to the fabrication process of photovoltaic cells, when ITO is exposed to hydrogen plasma, there is a danger that In or Sn may be reduced, thereby deteriorating electrical-optical characteristics. Therefore, at present, the development of transparent conductive oxides that can substitute for ITO is becoming an important issue.

Among them, a zinc oxide (ZnO)-based thin film is gaining interest as a substance that can substitute for the thin film made of the ITO conductive transparent oxide, due to superior electrical conductivity in the infrared (IR) and visible light range, excellent durability to plasma, low temperature machinability and the inexpensiveness of the raw material.

The ZnO-based thin film can be fabricated by a variety of methods, such as sputtering, E-beam evaporation, low pressure chemical vapor deposition (LPCVD) or atmospheric pressure chemical vapor deposition (APCVD). However, APCVD is unique as a method that is connected in-line to a glass manufacturing process and is available for mass production. However, when the ZnO-based thin film is fabricated by CVD, concaves and convexes are formed on the surface since the thin film grows along the ZnO crystal surface. In this case, the charge is stored in the edges of concaves and convexes, and a leakage current is apt to flow between the thin film and the overlying electrode, such that the device can easily deteriorate, which is problematic. The leakage current is connected directly with not only the decreased efficiency of the device but also the longevity of the device. Accordingly, a significant amount of effort is being done in order to reduce the leakage current.

In the related art, in order to overcome this, a method of planarizing the surface of the ZnO thin film by polishing it by chemical mechanical planarization (CMP) was used. However, the added polishing process increases the material cost and process cost, thereby increasing the fabrication cost, which is problematic.

### BRIEF SUMMARY OF THE INVENTION

Various aspects of the present invention provide a transparent conductive oxide thin film substrate that has a high level of surface flatness, a method of fabricating the same, and an organic light-emitting device (OLED) and photovoltaic cell having the same.

Also provided are a transparent conductive oxide thin film substrate that is electrically reliable and chemically stable, a method of fabricating the same, and an OLED and photovoltaic cell having the same.

In an aspect of the present invention, provided is a transparent conductive oxide thin film substrate that includes: a base substrate; a first transparent conductive oxide thin film formed on the base substrate, the first transparent conductive oxide thin film comprising a first dopant; and a second transparent conductive oxide thin film formed on the first transparent conductive oxide thin film, the second transparent conductive oxide thin film comprising a second dopant at a higher concentration than the first dopant. The surface of the second transparent conductive oxide thin film is flatter than the surface of the first transparent conductive oxide thin film. Specifically, the first transparent conductive oxide thin film comprises a first dopant such that a content ratio of the first dopant ranges, by weight, from 4.5 to 7.0 percent and the second transparent conductive oxide thin film comprises a second dopant at a higher concentration than the first dopant in the first transparent conductive oxide thin film such that a content ratio of the second dopant ranges, by weight, from 7.5 to 9.5 percent.

The root mean square (RMS) of the surface roughness of the first and second transparent conductive oxide thin films may be 5nm or less.

Each of the first dopant and the second dopant may be at least one selected from among Al, Ga, B, In and F.

Each of the first transparent conductive oxide thin film and the second transparent conductive oxide thin film may be composed of one selected from among In₂O₃, ZnO and SnO₂.

The total of the thickness of the first transparent conductive oxide thin film and the thickness of the second transparent conductive oxide thin film may range from 150 to 250nm.

In another aspect of the present invention, provided is a method of forming a transparent conductive oxide thin film substrate as defined in claim 7. The method includes the following steps of: depositing a first transparent conductive oxide thin film on a base substrate, the first transparent conductive oxide thin film being treated with a first dopant such that a content ratio of the first dopant ranges, by weight, from 4.5 to 7.0 percent; and depositing a second transparent conductive oxide thin film on the first transparent conductive oxide thin film, wherein a surface of the second transparent conductive oxide thin film is flatter than a surface of the first transparent conductive oxide thin film, the second transparent conductive oxide thin film being treated with a second dopant at a higher concentration than the first dopant in the first transparent conductive oxide thin film such that a content ratio of the second dopant ranges, by weight, from 7.5 to 9.5 percent.

Each of the first dopant and the second dopant may be at least one selected from among Al, Ga, B, In and F. Preferably, the first dopant and the second dopant may include the same substance. However, the present invention is not limited thereto, and they may include different substances.

Each of the first transparent conductive oxide thin film and the second transparent conductive oxide thin film may be composed of one selected from among In₂O₃, ZnO and SnO₂. Preferably, the first transparent conductive oxide thin film and the second transparent conductive oxide thin film may include the same substance. However, the present invention is not limited thereto, and they may include different substances.

The step of depositing the first transparent conductive oxide thin film and the step of depositing the second transparent conductive oxide thin film may include depositing the second transparent conductive oxide thin film on the first transparent conductive oxide thin film in-situ via chemical vapor deposition (CVD).

In a further aspect of the present invention, provided is an organic electroluminescent device that includes the above-mentioned transparent conductive oxide thin film substrate as an anode substrate.

In a further another aspect of the present invention, provided is a photovoltaic cell that includes the above-mentioned transparent conductive oxide thin film substrate as a transparent electrode substrate.

According to embodiments of the present invention, it is possible to improve the flatness of the surface of a transparent conductive oxide thin film structure by depositing a transparent conductive oxide thin film having a high doping concentration on a transparent conductive oxide thin film having a low doping concentration. This consequently makes it possible to increase the electrical reliability and chemical stability of a variety of devices, such as an OLED or a photovoltaic cell, which employs the transparent conductive oxide thin film structure, and ultimately increase the longevity of the devices.

In addition, since a transparent conductive oxide thin film having a high doping concentration is deposited in-situ on a transparent conductive oxide thin film having a low doping concentration during CVD, it is possible to simplify the process of fabricating transparent conductive oxide thin films and reduce the fabrication cost.

The methods and apparatuses of the present invention have other features and advantages which will be apparent from, or are set forth in greater detail in the accompanying drawings, which are incorporated herein, and in the following detailed description of the invention, which together serve to explain certain principles of the present invention.

### BRIEF DESCRIPTION OF THE DRAWINGS

FIG. 1 is a cross-sectional view showing a transparent conductive oxide thin film substrate according to an embodiment of the present invention;
FIG. 2 is a view showing surface images depending on the doping content of a first transparent conductive oxide thin film in transparent conductive oxide thin film substrates according to an example of the present invention and a comparative example; and
FIG. 3 is a view showing surface images depending on the doping content of a second transparent conductive oxide thin film in transparent conductive oxide thin film substrates according to an example of the present invention and another comparative example.

### DETAILED DESCRIPTION OF THE INVENTION

Reference will now be made in detail to a transparent conductive oxide thin film substrate, a method of fabricating the same, and an organic light-emitting device (OLED) and photovoltaic cell having the same according to the present invention, embodiments of which are illustrated in the accompanying drawings and described below, so that a person having ordinary skill in the art to which the present invention relates can easily put the present invention into practice.

Throughout this document, reference should be made to the drawings, in which the same reference numerals and signs are used throughout the different drawings to designate the same or similar components. In the following description of the present invention, detailed descriptions of known functions and components incorporated herein will be omitted when they may make the subject matter of the present invention unclear.

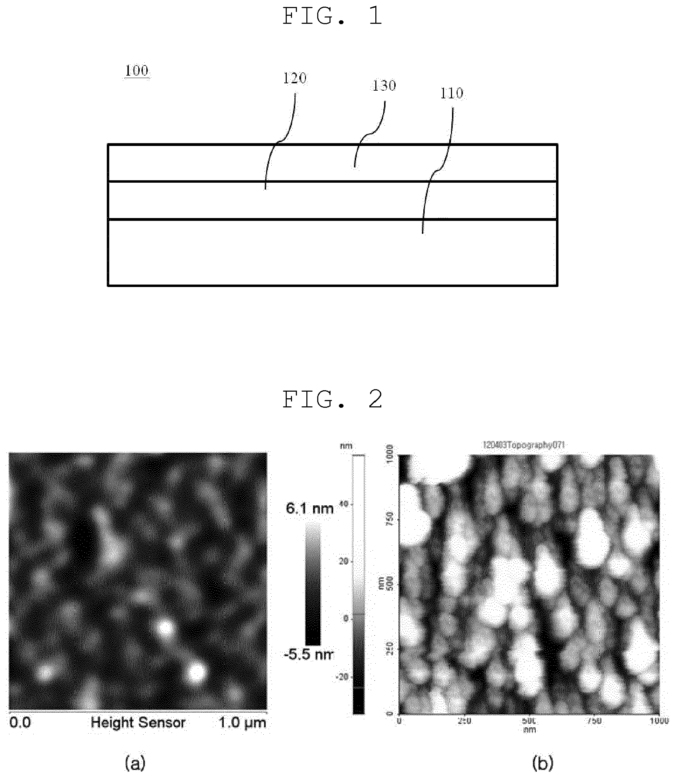

As shown in FIG. 1, a transparent conductive oxide thin film substrate 100 according to an embodiment of the present invention includes a base substrate 110, a first transparent conductive oxide thin film 120 and a second transparent conductive oxide thin film 130.

The base substrate 110 is a base on which the first and second transparent conductive oxide thin films 120 and 130 are formed, and is also a support substrate which supports the first and second transparent conductive oxide thin films 120 and 130. The base substrate 110 can be implemented as a glass substrate.

The first transparent conductive oxide thin film 120 is formed on one surface of the base substrate 110. The transparent conductive oxide thin film 120 can be deposited on the base substrate 110 by chemical vapor deposition (CVD), which leaves concaves and convexes on the surface of the first transparent conductive oxide thin film 120.

The first transparent conductive oxide thin film 120 can contain one selected from among In₂O₃, ZnO and SnO₂. The first transparent conductive oxide thin film 120 is treated with a dopant. The dopant can be at least one selected from among Al, Ga, B, In and F. The content ratio of the dopant added to the first transparent conductive oxide thin film 120 ranges, by weight, from 4.5 to 7.0 percent.

The second transparent conductive oxide thin film 130 is formed on one surface of the first transparent conductive oxide thin film 120. The second transparent conductive oxide thin film 130 is deposited in-situ on the first transparent conductive oxide thin film 120 by CVD. This will be discussed in more detail later in the description of a method of fabricating a transparent conductive oxide thin film.

The second transparent conductive oxide thin film 130 can contain the same substance as the first transparent conductive oxide thin film 120, for example, one substance selected from among In₂O₃, ZnO and SnO₂. In addition, the second transparent conductive oxide thin film 130 is also treated with a dopant that can be at least one selected from among Al, Ga, B, In and F. The dopant added to the first transparent conductive oxide thin film 120 and the dopant added to the second transparent conductive oxide thin film 130 can be the same substance.

Here, the second transparent conductive oxide thin film 130 serves as a flat film that planarizes the first transparent conductive oxide thin film 120 which has concaves and convexes on the surface. For this, according to an embodiment of the present invention, the concentration of the dopant added to the second transparent conductive oxide thin film 130 is set higher than the concentration of the dopant added to the first transparent conductive oxide thin film 120. Accordingly, the content ratio of the dopant added to the second transparent conductive oxide thin film 130 ranges, by weight, from 7.5 to 9.5 percent.

When the concentration of the dopant added to the second transparent conductive oxide thin film 130 becomes higher than the concentration of the dopant added to the first transparent conductive oxide thin film 120, the grain size of a substance that forms the second transparent conductive oxide thin film 130, for example, ZnO, is reduced. This is because Zn and the dopant have different ion radii and dopant segregation occurs at the grain boundary during high-concentration doping. Due to this phenomenon in which the grain size is reduced, the surface of the second transparent conductive oxide thin film 130 is planarized. That is, the surface flatness of the second transparent conductive oxide thin film 130 is higher than that of the first transparent conductive oxide thin film 120.

According to an embodiment of the present invention, the root mean square (RMS) of the surface roughness of the first transparent conductive oxide thin film 120 which is treated with a dopant at a low concentration and the transparent conductive oxide thin film 130 which is treated with a dopant at a high concentration and the surface of which is planarized can be controlled to be 5nm or less. When the RMS of the surface roughness is set to 5nm or less, it is possible to improve the electrical characteristics by preventing deterioration by decreasing leakage current. Accordingly, the transparent conductive oxide thin film substrate 100 has a sheet resistance of 15Ω/□ or less.

In general, a leakage current value tends to increase as the surface roughness increases, that is, the surface becomes rougher. In contrast, the leakage current value tends to decrease as the source roughness decreases, that is, the flatness of the surface is higher. In other words, as in an embodiment of the present invention, it is possible to increase the flatness of the surface by treating the second transparent conductive oxide thin film 130 with a dopant at a high concentration, thereby decreasing leakage current. In addition, it is possible to realize electrical reliability and chemical stability by increasing the flatness of the second transparent conductive oxide thin film 130. It is therefore possible to increase the longevity of a variety of devices, for example, an OLED or a photovoltaic cell which employs the transparent conductive oxide thin film substrate 100 according to an embodiment of the present invention as a transparent electrode.

The second transparent conductive oxide thin film 130 can be configured such that the total thickness of the first and second transparent conductive oxide thin films 120 and 130 ranges from 150 to 250nm.

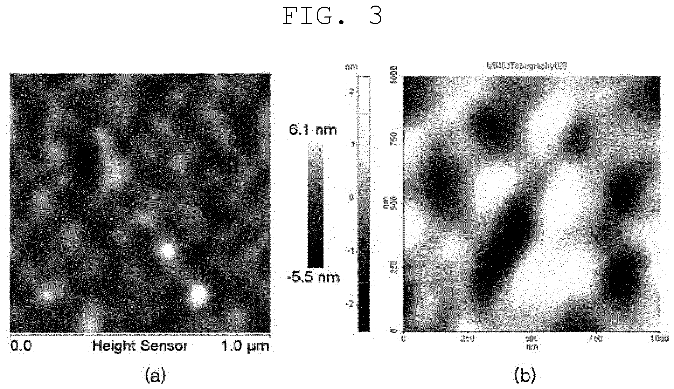

In addition, FIG. 2 and FIG. 3 show image views comparatively showing variations in the surface roughness depending on the doping content of a first transparent conductive oxide thin film and a second transparent conductive oxide thin film.

First, FIG. 2 shows the surface images depending on the doping content of the first transparent conductive oxide thin film in transparent conductive oxide thin film substrates according to an example of the present invention and a comparative example. Here, the part (a) in FIG. 2 shows a bi-layer structure in which the first conductive oxide thin film and the second transparent oxide thin film are stacked on each other according to an example of the present invention. The first transparent conductive oxide thin film was treated at a dopant concentration of 4.8wt%, and the second transparent conductive oxide thin film was treated at a dopant concentration of 7.9w%. After that, the surface roughness of the bi-layer structure was measured, and the surface image was photographed. The part (b) in FIG. 2 is the surface image of a comparative example. Here, the first transparent conductive oxide thin film was treated at a dopant concentration of 3.9wt%, and the second transparent conductive oxide thin film was treated at a dopant concentration of 7.9wt%. After that, the surface roughness was measured, and the surface image was photographed. Accordingly, FIG. 2 shows the result obtained by measuring a variation in the surface roughness depending on the differing concentration of the dopant added to the first transparent conductive oxide thin film after setting the content ratio of the dopant added to the second transparent conductive oxide thin film to be equal and varying the content ratio of the dopant added to the first transparent conductive oxide thin film.

Referring to FIG. 2, as for the part (a) in which the first transparent conductive oxide thin film was treated with the dopant concentration of 4.8wt%, the peak-to-valley roughness (RPV) was measured 15.8nm, and the root mean square (RMS) of the surface roughness was measured 1.9nm. In contrast, as for the part (b) in which the first transparent conductive oxide thin film was treated with the dopant concentration of 3.9wt%, the RPV was measured 90.1nm, and the RMS of the surface roughness was measured 13.0nm. It can be visually confirmed that the surface of the part (b) according to a comparative example is rougher. In this fashion, the variation in the surface roughness depending on the differing dopant concentration can be verified from FIG. 2.

In addition, FIG. 3 shows the surface images depending on the doping content of the first transparent conductive oxide thin film in transparent conductive oxide thin film substrates according to an example of the present invention and another comparative example. Here, the part (a) in FIG. 3 shows a bi-layer structure in which the first conductive oxide thin film and the second transparent oxide thin film are stacked on each other according to an example of the present invention. The first transparent conductive oxide thin film was treated at a dopant concentration of 4.8wt%, and the second transparent conductive oxide thin film was treated at a dopant concentration of 7.9w%. After that, the surface roughness and the sheet resistance of the bi-layer structure were measured, and the surface image was photographed. The part (b) in FIG. 3 is the surface image of another comparative example. Here, the first transparent conductive oxide thin film was treated at a dopant concentration of 4.8wt%, and the second transparent conductive oxide thin film was treated at a dopant concentration of 9.9wt%. After that, the surface roughness and the sheet resistance were measured, and the surface image was photographed. Accordingly, FIG. 3 shows the result obtained by measuring variations in the surface roughness and the sheet resistance depending on the differing concentration of the dopant added to the second transparent conductive oxide thin film after setting the content ratio of the dopant added to the first transparent conductive oxide thin film to be equal and varying the content ratio of the dopant added to the second transparent conductive oxide thin film.

Referring to FIG. 3, as for the part (a) in which the second transparent conductive oxide thin film was treated with the dopant concentration of 7.9wt%, the peak-to-valley roughness (RPV) was measured 15.8nm, and the root mean square (RMS) of the surface roughness was measured 1.9nm. In contrast, as for the part (b) in which the second transparent conductive oxide thin film was treated with the dopant concentration of 9.9wt%, the RPV was measured 4.8nm, and the RMS of the surface roughness was measured 0.81nm. It was observed that the surface flatness of the part (b) according to another comparative example was better than that of the part (a). However, the sheet resistance of the part (a) was measured 14.4Ω/□, whereas the sheet resistance of the part (b) was measured 24.4Ω/□, which is higher than the sheet resistance of the part (a). Based on these results, it can be appreciated that the superior flatness of the surface can be realized by increasing the concentration of the dopant added to the second transparent conductive oxide thin film but the sheet resistance increases when the concentration of the dopant increases to or above a predetermined value. Accordingly, while the concentration of the dopant added to the second transparent conductive oxide thin film is preferably set high for the purpose of planarization of the surface, whereas the high concentration of the dopant is required to be limited to a predetermined range. The content ratio of the dopant added to the second transparent conductive oxide thin film is therefore limited to the range from 7.5 to 9.5wt%. This is because the transparent conductive oxide thin film substrate must have superior electrical characteristics since it is used as a transparent electrode of an OLED or a photovoltaic cell.

Table 1 below presents the measurement results of the surface roughness and sheet resistance of other comparative examples when the content ratio of the dopant is beyond the range of the content ratio of the dopant according to an example of the present invention.

**Table 1**

| | 1^{st} layer (wt%) | 2^{nd} layer (wt%) | RMS (nm) | Sheet resistance (Ω/□) |
|---|---|---|---|---|
| Comp. ex. 1 | 8.1 | 8.1 | 30.1 | 15.3 |
| Comp. ex. 2 | 13.3 | 7.1 | 3 | 25.3 |
| Comp. ex. 3 | 11.8 | 11.8 | 3.5 | 40.7 |
| Comp. ex. 4 | 6.2 | 6.2 | 13.8 | 16.9 |

First, as for comparative example 1, the content of the dopant added to the first transparent conductive oxide thin film exceeds the dopant content range according to an example of the present invention, and the content of the dopant added to the second transparent conductive oxide thin film is within the dopant content range according to an example of the present invention. In this case, both of the RMS of the surface roughness and the sheet resistance were measured higher than those of an example of the present invention. In addition, as for comparative example 2, the content of the dopant added to the first transparent conductive oxide thin film exceeds the upper limit of the dopant content range according to an example of the present invention, and the content of the dopant added to the second transparent conductive oxide thin film is smaller than the lower limit of the dopant content range according to an example of the present invention. In this case, the RMS of the surface roughness was measured lower than that of an example of the present invention, whereas the sheet resistance was measured higher than that of an example of the present invention. Furthermore, as for comparative example 3, the content ratio of the dopant added to the first transparent conductive oxide thin film and the content ratio of the dopant added to the second transparent conductive oxide thin film exceed the upper limit of the dopant content ranges according to an example of the present invention. In this case, the RMS of the surface roughness was measured lower, whereas the sheet resistance was measured highest. In addition, as for comparative example 4, the content of the dopant added to the first transparent conductive oxide thin film is within the dopant content range according to an example of the present invention, whereas the content of the dopant added to the second transparent conductive oxide thin film is smaller than the lower limit of the dopant content range according to an example of the present invention. In this case, like comparative example 1, both of the RMS of the surface roughness and the sheet resistance were measured higher than those of an example of the present invention.

In addition, according to an embodiment of the present invention, the transparent conductive oxide thin film substrate can include an inner light extraction layer (not shown) which serves to improve light extraction efficiency when applied as an anode substrate of an OLED. The inner light extraction layer (not shown) can be disposed between the base substrate 110 and the first transparent conductive oxide thin film 120. The inner light extraction layer (not shown) can be implemented as a scattering particle layer which is made of SiO₂, TiO₂, Al₂O₃ or a mixture layer thereof, an index matching layer which is made of SiO₂, TiO₂, Al₂O₃, SiNₓ or a multilayer thin film thereof, or a scattering grid layer.

In addition, according to an embodiment of the present invention, the transparent conductive oxide thin film substrate 100 can include an outer light extraction layer (not shown) which is disposed on the other surface of the base substrate 110 that faces one surface of the base substrate 110 on which the first transparent conductive oxide thin film 120 is formed.

As described above, the transparent conductive oxide thin film substrate according to an embodiment of the present invention that has the improved surface flatness due to the bi-layer structure of the first transparent conductive oxide thin film 120 having a low doping concentration and the second transparent conductive oxide thin film 130 having a low doping concentration can be used as a transparent conductive electrode of a variety of electronic devices, for example, as an anode electrode substrate of an OLED. Although not shown in detail, the OLED has a multilayer structure which includes an anode, an organic light-emitting layer and a cathode, the multilayer structure being situated between encapsulating substrates which face each other. In the transparent conductive oxide thin film substrate 100 according to an embodiment of the present invention, the first transparent conductive oxide thin film 120 and the second transparent conductive oxide thin film 130 can be applied as an anode, and the base substrate 110 can be applied as one of the encapsulating substrates which support the anode. The cathode can be formed as a metal thin film made of Al, Al:Li or Mg:Ag which has a small work function in order to facilitate electron injection. In the case of a top-emission structure, the cathode can have a multilayer structure which includes a semitransparent electrode of a metal thin film made of Al, Al:Li or Mg:Ag and a transparent electrode of an oxide thin film which is made of indium tin oxide (ITO) in order to facilitate transmission of light that is generated by the organic light-emitting layer. In addition, the organic light-emitting layer includes a hole injection layer, a hole transport layer, an emitting layer, an electron transport layer and an electron injection layer which are sequentially stacked on the anode. In this structure, when a forward voltage is applied between the anode and the cathode, electrons from the cathode migrate to the emitting layer through the electron injection layer and the electron transport layer, and holes from the anode migrate to the emitting layer through the hole injection layer and the hole transport layer. The electrons and holes that have migrated into the emitting layer recombine with each other, thereby generating excitons. When such excitons transit from the excited state to the ground state, light is emitted. The brightness of light that is emitted in this fashion is proportional to the amount of current that flows between the anode and the cathode.

The transparent conductive oxide thin film substrate 100 according to an embodiment of the present invention can be used as a transparent electrode of a photovoltaic cell. The photovoltaic cell is an electrical device that converts the energy of light, for example, solar energy, directly into electricity.

Although not specifically shown, the photovoltaic module can have a multilayer structure in which a cover glass, a first buffer member, a photovoltaic cell, a second buffer member and a rear sheet are sequentially stacked on each other. The cover glass serves to protect the battery cell from the external environment such as moisture, dust or damage. In addition, the buffer members serve to protect the battery cell from the external environment such as moisture penetration, and encapsulate the battery cell by bonding it to the cover glass. The buffer members can be made of ethylene vinyl acetate (EVA). The battery cell is formed as a power generating device which generates a voltage and current in response to, for example, sunlight. For example, the battery cell can include a transparent conductive oxide electrode, a light-absorbing layer, a back electrode layer and an insulator film. Examples of the material for the light-absorbing layer can include a semiconductor compound, such as single crystal or polycrystal silicon, copper indium gallium Selenide (CIGS) or cadmium telluride (CdTe); a dye-sensitizer in which photosensitive dye molecules are adsorbed on the surface of nano particles of a porous film such that electrons are activated when the photosensitive dye molecules absorb visible light; amorphous silicon; or the like. In the transparent conductive oxide thin film substrate 100 according to an embodiment of the present invention, the first transparent conductive oxide thin film 120 and the second transparent conductive oxide thin film 130 can be applied as a transparent conductive oxide electrode of the battery cell, and the base substrate 110 can serve as a support substrate which supports the transparent conductive oxide electrode.

A description will be given below of a method of fabricating the transparent conductive oxide thin film substrate according to an embodiment of the present invention. In the description of the method of fabricating the transparent conductive oxide thin film substrate according to an embodiment of the present invention, reference numerals of the transparent conductive oxide thin film substrate shown in FIG. 1 will be referred to.

In the method of fabricating the transparent conductive oxide thin film substrate according to an embodiment of the present invention, first, the first transparent conductive oxide thin film 120 is deposited on the base substrate 110. The first transparent conductive oxide thin film 120 can be made of one selected from among In₂O₃, ZnO and SnO₂. The first transparent conductive oxide thin film 120 can be formed by one selected from among atmospheric pressure chemical vapor deposition (APCVD), low pressure chemical vapor deposition (LPCVD), sputtering and molecular beam epitaxy, and most preferably, by APCVD.

The APCVD process includes loading the base substrate 110 into a process chamber (not shown), followed by heating at a predetermined temperature. Afterwards, a precursor gas and an oxidizer gas which will form the first transparent conductive oxide thin film 120 are blown into the process chamber (not shown). It is preferable to control the precursor gas and the oxidizer gas to be fed along different gas feed paths in order to prevent the gases from mixing before entering the process chamber (not shown). The precursor gas and the oxidizer gas can be preheated before being fed in order to promote a chemical reaction. Here, the precursor gas can be fed on a carrier gas into the process chamber (not shown), the carrier gas being implemented as an inert gas such as nitrogen, helium or argon.

After the first transparent conductive oxide thin film 120 is deposited on the base substrate 110 by APCVD in this way, the first transparent conductive oxide thin film 120 is treated with a dopant at a content ratio ranging, by weight, from 4.5 to 7.0 percent of the first transparent conductive oxide thin film 120, the dopant being at least one selected from among Al, Ga, B, In and F.

After that, the second transparent conductive oxide thin film 130 made of the same substance as the first transparent conductive oxide thin film 120 is deposited in-situ on the first transparent conductive oxide thin film 120, and is then treated with a dopant at a content ratio ranging, by weight, from 7.5 to 9.5 percent of the second transparent conductive oxide thin film 130.

As described above, when the first transparent conductive oxide thin film 120 having a low doping concentration is deposited by APCVD, and the second transparent conductive oxide thin film 130 having a high doping concentration is deposited in-situ on the first transparent conductive oxide thin film 120, the fabrication of the transparent conductive oxide thin film substrate 100 according to an embodiment of the present invention is completed.

## Claims

1. A transparent conductive oxide thin film substrate (100) comprising:
a base substrate (110);
a first transparent conductive oxide thin film (120) formed on the base substrate (110; and
a second transparent conductive oxide thin film (130) formed on the first transparent conductive oxide thin film (120), wherein a surface of the second transparent conductive oxide thin film (130) is flatter than a surface of the first transparent conductive oxide thin film (120),
**characterized in that** the first transparent conductive oxide thin film (120) comprises a first dopant, the content ratio of the first dopant ranging, by weight, from 4.5 to 7.0 percent and the second transparent conductive oxide thin film (130) comprises a second dopant at a higher concentration than the first dopant in the first transparent conductive oxide thin film, the content ratio of the second dopant ranging, by weight, from 7.5 to 9.5 percent.

2. The transparent conductive oxide thin film substrate of claim 1, wherein a root mean square (RMS) of a surface roughness of the first and second transparent conductive oxide thin films (120, 130) is 5nm or less, and/or
wherein a total of a thickness of the first transparent conductive oxide thin film (120) and a thickness of the second transparent conductive oxide thin film (130) ranges from 150 to 250nm.

3. The transparent conductive oxide thin film substrate of claim 1, wherein each of the first dopant and the second dopant is at least one selected from the group consisting of Al, Ga, B, In and F.

4. The transparent conductive oxide thin film substrate of claim 1, wherein the first dopant and the second dopant comprises the same substance or different substances.

5. The transparent conductive oxide thin film substrate of claim 1, wherein each of the first transparent conductive oxide thin film (120) and the second transparent conductive oxide thin film (130) comprises one selected from the group consisting of In₂O₃, ZnO and SnO₂.

6. The transparent conductive oxide thin film substrate of claim 1, wherein each of the first transparent conductive oxide thin film (120)and the second transparent conductive oxide thin film (130) comprises the same substance or different substances.

7. A method of forming a transparent conductive oxide thin film substrate (100) recited in claim 1, comprising:
depositing a first transparent conductive oxide thin film (120) on a base substrate, the first transparent conductive oxide thin film being treated with a first dopant such that a content ratio of the first dopant ranges, by weight, from 4.5 to 7.0 percent; and
depositing a second transparent conductive oxide thin film (130) on the first transparent conductive oxide thin film (120), wherein a surface of the second transparent conductive oxide thin film (130) is flatter than a surface of the first transparent conductive oxide thin film (120), the second transparent conductive oxide thin film (130) being treated with a second dopant at a higher concentration than the first dopant in the first transparent conductive oxide thin film such that a content ratio of the second dopant ranges, by weight, from 7.5 to 9.5 percent.

8. The method of claim 7, wherein depositing the first transparent conductive oxide thin film (120) and depositing the second transparent conductive oxide thin film (130) comprise depositing the second transparent conductive oxide thin film (130) on the first transparent conductive oxide thin film (120) in-situ via chemical vapor deposition.

9. An organic light-emitting device comprising the transparent conductive oxide thin film substrate (100) recited in claim 1 as an anode substrate.

10. A photovoltaic cell comprising the transparent conductive oxide thin film substrate (100) recited in claim 1 as a transparent electrode substrate.

## Patentansprüche

1. Transparentes Dünnfilmsubstrat (100) mit leitfähigem Oxid, umfassend:
ein Basissubstrat (110);
einen ersten transparenten Dünnfilm (120) aus leitfähigem Oxid, der auf dem Basissubstrat (110) gebildet ist; und
einen zweiten transparenten Dünnfilm (130) aus leitfähigem Oxid auf dem ersten transparenten Dünnfilm (120) aus leitfähigem Oxid, wobei eine Fläche des zweiten transparenten Dünnfilms (130) aus leitfähigem Oxid flacher als eine Fläche des ersten transparenten Dünnfilms (120) aus leitfähigem Oxid ist,
**dadurch gekennzeichnet, dass** der erste transparente Dünnfilm (120) aus leitfähigem Oxid ein erstes Dotierungsmittel enthält, wobei das Anteilsverhältnis des ersten Dotierungsmittels nach Gewicht von 4,5 bis 7,0 % reicht, und der zweite transparente Dünnfilm (130) aus leitfähigem Oxid enthält ein zweites Dotierungsmittel mit einer höheren Konzentration als das erste Dotierungsmittel im ersten transparenten Dünnfilm aus leitfähigem Oxid, wobei das Anteilsverhältnis des zweiten Dotierungsmittels nach Gewicht von 7,5 bis 9,5 % reicht.

2. Transparentes Dünnfilmsubstrat aus leitfähigem Oxid nach Anspruch 1, wobei ein quadratischer Mittelwert (RMS) einer Oberflächenrauheit des ersten und zweiten transparenten Dünnfilms (120, 130) aus leitfähigem Oxid 5 nm oder weniger beträgt, und/oder wobei ein Gesamtwert einer Dicke des ersten transparenten Dünnfilms (120) aus leitfähigem Oxid und eine Dicke des zweiten transparenten Dünnfilms (130) aus leitfähigem Oxid von 150-250 nm reicht.

3. Transparentes Dünnfilmsubstrat aus leitfähigem Oxid nach Anspruch 1, wobei jedes Dotierungsmittel aus dem ersten Dotierungsmittel und dem zweiten Dotierungsmittel mindestens eines ist, das aus der Gruppe bestehend aus Al, Ga, B, In und F ausgewählt wird.

4. Transparentes Dünnfilmsubstrat aus leitfähigem Oxid nach Anspruch 1, wobei das erste Dotierungsmittel und das zweite Dotierungsmittel dieselbe Substanz oder unterschiedliche Substanzen umfassen.

5. Transparentes Dünnfilmsubstrat aus leitfähigem Oxid nach Anspruch 1, wobei sowohl der erste transparente Dünnfilm (120) aus leitfähigem Oxid als auch der zweite transparente Dünnfilm (130) aus leitfähigem Oxid einer ist, der aus der Gruppe bestehend aus In₂O₃, ZnO und SnO₂ ausgewählt wird.

6. Transparentes Dünnfilmsubstrat aus leitfähigem Oxid nach Anspruch 1, wobei sowohl der erste transparente Dünnfilm (120) aus leitfähigem Oxid als auch der zweite transparente Dünnfilm (130) aus leitfähigem Oxid dieselbe Substanz oder unterschiedliche Substanzen umfassen.

7. Verfahren zum Bilden eines transparenten Dünnfilmsubstrats (100) aus leitfähigem Oxid nach Anspruch 1, umfassend:
Abscheiden eines ersten transparenten Dünnfilms (120) aus leitfähigem Oxid auf einem Basissubstrat, wobei der erste transparente Dünnfilm aus leitfähigem Oxid mit einem ersten Dotierungsmittel derart behandelt wird, dass ein Anteilsverhältnis des ersten Dotierungsmittels nach Gewicht von 4,5 bis 7,0 % reicht; und
Abscheiden eines zweiten transparenten Dünnfilms (130) aus leitfähigem Oxid auf dem ersten transparenten Dünnfilm (120) aus leitfähigem Oxid, wobei eine Fläche des zweiten transparenten Dünnfilms (130) aus leitfähigem Oxid flacher als eine Fläche des ersten transparenten Dünnfilms (120) aus leitfähigem Oxid ist, wobei der zweite transparente Dünnfilm (130) aus leitfähigem Oxid mit einem zweiten Dotierungsmittel bei einer höheren Konzentration als das erste Dotierungsmittel im ersten transparenten Dünnfilm aus leitfähigem Oxid derart behandelt wird, dass ein Anteilsverhältnis des zweiten Dotierungsmittels nach Gewicht von 7,5 bis 9,5 % reicht.

8. Verfahren nach Anspruch 7, wobei das Abscheiden des ersten transparenten Dünnfilms (120) aus leitfähigem Oxid und das Abscheiden des zweiten transparenten Dünnfilms (130) aus leitfähigem Oxid das Abscheiden des zweiten transparenten Dünnfilms (130) aus leitfähigem Oxid auf dem ersten transparenten Dünnfilm (120) aus leitfähigem Oxid in situ durch chemische Dampfabscheidung umfasst.

9. Organische lichtemittierende Vorrichtung, die das transparente Dünnfilmsubstrat (100) aus leitfähigem Oxid nach Anspruch 1 als Anodensubstrat umfasst.

10. Fotovoltaische Zelle, die das transparente Dünnfilmsubstrat (100) aus leitfähigem Oxid nach Anspruch 1 als transparentes Elektrodensubstrat enthält.

## Revendications

1. Substrat à couche mince d'oxyde conductrice transparente (100) comprenant :
un substrat de base (110) ;
une première couche mince d'oxyde conductrice transparente (120) formée sur le substrat de base (110) ; et
une seconde couche mince d'oxyde conductrice transparente (130) formée sur la première couche mince d'oxyde conductrice transparente (120), dans lequel une surface de la seconde couche mince d'oxyde conductrice transparente (130) est plus plate qu'une surface de la première couche mince d'oxyde conductrice transparente (120),
**caractérisé en ce que** la première couche mince d'oxyde conductrice transparente (120) comprend un premier dopant, le rapport de teneur du premier dopant étant compris, en poids, entre 4,5 et 7,0 % et la seconde couche mince d'oxyde conductrice transparente (130) comprend un second dopant à une concentration plus élevée que le premier dopant dans la première couche mince d'oxyde conductrice transparente, le rapport de teneur du premier dopant étant compris, en poids, entre 7,5 et 9,5 %.

2. Substrat à couche mince d'oxyde conductrice transparente selon la revendication 1, dans lequel une valeur quadratique moyenne (RMS) d'une rugosité de surface de la première et de la seconde couche mince d'oxyde conductrice transparente (120, 130) est inférieure ou égale à 5 mm, et/ou dans lequel une valeur totale d'une épaisseur de la première couche mince d'oxyde conductrice transparente (120) et une épaisseur de la seconde couche mince d'oxyde de vente (130) est comprise entre 150 et 250 nm.

3. Substrat à couche mince d'oxyde conductrice transparente selon la revendication 1, dans lequel chacun du premier dopant et du second dopant est au moins un élément choisi dans le groupe constitué par Al, Ga, B, In et F.

4. Substrat à couche mince d'oxyde conductrice transparente selon la revendication 1, dans lequel le premier dopant et le second dopant comprennent la même substance ou des substances différentes.

5. Substrat à couche mince d'oxyde conductrice transparente selon la revendication 1, dans lequel chacun de la première couche mince d'oxyde conductrice transparente (120) et de la seconde couche mince d'oxyde conductrice transparente (130) comprend un élément choisi dans le groupe constitué par In₂O₃, ZnO et SnO₂.

6. Substrat à couche mince d'oxyde conductrice transparente selon la revendication 1, dans lequel chacun de la première couche mince d'oxyde conductrice transparente (120) et de la seconde couche mince d'oxyde conductrice transparente (130) comprend la même substance ou des substances différentes.

7. Procédé de formation d'un substrat à couche mince d'oxyde conductrice transparente (100) selon la revendication 1, comprenant :
le dépôt d'une première couche mince d'oxyde conductrice transparente (120) sur un substrat de base, la première couche mince d'oxyde conductrice transparente étant traitée avec un premier dopant de sorte qu'un rapport de teneur du premier dopant soit compris, en poids, entre 4,5 et 7,0 % ; et
le dépôt d'une deuxième couche mince d'oxyde conductrice transparente (130) sur la première couche mince d'oxyde conductrice transparente (120), dans lequel une surface de la seconde couche mince d'oxyde conductrice transparente (130) est plus plate qu'une surface de la première couche mince d'oxyde conductrice transparente (120), la seconde couche mince d'oxyde conductrice transparente (130) étant traitée avec un second dopant à une concentration plus élevée que le premier dopant dans la première couche mince d'oxyde conductrice transparente de sorte qu'un rapport de teneur du second dopant soit compris, en poids, entre 7,5 et 9,5 %.

8. Procédé selon la revendication 7, dans lequel le dépôt de la première couche mince d'oxyde conductrice transparente (120) et le dépôt de la seconde couche mince d'oxyde conductrice transparente (130) comprennent le dépôt in situ de la seconde couche mince d'oxyde conductrice transparente (130) sur la première couche mince d'oxyde conductrice transparente (120) par l'intermédiaire d'un dépôt chimique en phase vapeur.

9. Dispositif électroluminescent organique comprenant le substrat à couche mince d'oxyde conductrice transparente (100) selon la revendication 1 en tant que substrat d'anode.

10. Cellule photovoltaïque comprenant le substrat à couche mince d'oxyde conductrice transparente (100) selon la revendication 1 en tant que substrat d'électrode transparent.
